# EUROPEAN PATENT APPLICATION

(11) **EP 4 791 163 A1**
(43) Date of publication of application: **12.08.2026**
(21) Application number: 24875001.0
(22) Date of filing: 04.10.2024
(51) Int. Cl.: H10K 59/80, H10K 59/131, H10K 59/12, H10K 71/00, H10K 71/60

(54) **ORGANIC LIGHT-EMITTING DISPLAY DEVICE**

(30) Priority: 06.10.2023 KR 20230133720; 02.10.2024 KR 20240134277
(71) Applicant: Yas Co., Ltd., Paju-si, Gyeonggi-do 10857 (KR); Ahn, Byungchul, Seoul 06574 (KR)
(72) Inventor: AHN, Byungchul, Seoul 06574 (KR)
(74) Representative: Epping - Hermann - Fischer
(86) International application number: PCT/KR2024/015128
(87) International publication number: WO 2025/075446

(57) **Abstract**

An organic light-emitting display device may include a power wiring, a plurality of subpixels, a plurality of organic light-emitting elements in the plurality of subpixels, and a plurality of connection structures configured to connect plurality of cathode electrodes of the plurality of organic light-emitting elements to the power wiring around the plurality of subpixels. The plurality of subpixels may have different colors along a first direction and may have a same color along a second direction intersecting the first direction.

## Description

### [Technical Field]

The embodiment relates to an organic light-emitting display device.

### [Background Art]

As the demand for portable information media increases, attempts to apply an organic light-emitting display device to various lightweight and thin information electronic devices are expanding. Recently, the organic light-emitting display device is being applied to product groups such as a mobile PC and an automobile rather than a TV or a mobile phone. Since the organic light-emitting display device applied to mobile the PC or the automobiles is driven as still images for a long time, long lifespan is required. In order to achieve the long lifespan, the extraction of light from the organic light-emitting element equipped in the organic light-emitting display device should be maximized. In addition, in order to reduce cost, it is necessary to expand the technology to enable the production of organic light-emitting elements on the substrate of not only 8.5th generation (2200x2,500mm) but also 10.5th generation (3370x2940mm). In order to produce long-lifespan organic light-emitting elements, each subpixel with a top emission structure and a side-by-side structure must be implemented as a structure of an organic light-emitting element of two or more stacks.

The structure of an organic light-emitting element may be obtained through a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low PPA (pixel position accuracy) between the FMM and the substrate in a subpixel unit. Accordingly, the emission area ratio (EAR) is small, which limits the product lifespan. Here, the EAR is the value obtained by dividing the emission area of a subpixel by the total area of the subpixel.

Therefore, the development of a new deposition method to solve the aforementioned problems and an organic light-emitting display device having a structure of a new organic light-emitting element using the new deposition method is very urgent.

### [Disclosure]

### [Technical Problem]

An object of the embodiment is to solve the foregoing and other problems.

Another object of the embodiment is to provide an organic light-emitting display device having a new structure.

Another object of the embodiment is to provide an organic light-emitting display device capable of improving lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that may be understood through the description of the invention.

### [Technical Solution]

According to one aspect of the embodiment to achieve the above or other objects, an organic light-emitting display device, comprising: a power wiring; a plurality of subpixels; a plurality of organic light-emitting elements in the plurality of subpixels; and a plurality of connection structures configured to connect a plurality of cathode electrodes of the plurality of organic light-emitting elements to the power wiring around the plurality of subpixels, wherein the plurality of subpixels have different colors along a first direction and have a same color along a second direction intersecting the first direction.

The plurality of connection structures may be disposed lengthwise along the second direction between the plurality of subpixels.

The plurality of connection structures may be disposed between the plurality of subpixels in the second direction.

The power wiring may comprise a plurality of first power wirings along the first direction; and a plurality of second power wirings intersecting the plurality of first power wirings along the second direction, and the plurality of connection structures may be disposed in intersection regions where the plurality of first power wirings and the plurality of second power wirings intersect.

The organic light-emitting display device may further comprise a plurality of banks between the plurality of subpixels; and a plurality of protrusion parts comprising a bottom layer, a pillar layer on the bottom layer, and a roof layer on the pillar layer, respectively, on the plurality of banks, and the protrusion part may have undercut structures formed by the bottom layer, the pillar layer, and the roof layer.

At least one layer of the floor layer and the pillar layer may be an auxiliary electrode connected to the power wiring, and the connection structure may be in contact with the cathode electrode with an upper surface of the auxiliary electrode in the undercut structure.

The organic light-emitting display device may comprise an inorganic insulating layer on the plurality of organic light-emitting elements; and waterproof structures in the undercut structures.

The waterproof structure may be formed in a curved shape by the inorganic insulating layer with the undercut structure.

The organic light-emitting display device may further comprise an open structure between the plurality of subpixels, and a hole injection layer or a charge generation layer of the organic light-emitting layer may be separated by the open structure.

According to another aspect of the embodiment, an organic light-emitting display device, comprising: a power wiring; a plurality of subpixels; a plurality of organic light-emitting elements in the plurality of subpixels; and a plurality of connection structures configured to connect a plurality of cathode electrodes of the plurality of organic light-emitting elements to the power wiring around the plurality of subpixels, wherein the plurality of subpixels may comprise a plurality of first subpixels along a second direction; a plurality of second subpixels between the plurality of first subpixels in the second direction; and a plurality of third subpixels arranged in parallel with the plurality of first subpixels and the plurality of second subpixels in the second direction.

The plurality of connection structures may be disposed lengthwise along the second direction between the plurality of first subpixels and the plurality of third subpixels and between the plurality of second subpixels and the plurality of third subpixels.

The plurality of connection structures may comprise a plurality of first connection structures disposed lengthwise along the second direction between the plurality of first subpixels and the plurality of third subpixels and between the plurality of second subpixels and the plurality of third subpixels; and a plurality of second connection structures configured to branch in the first direction from the plurality of first connection structures.

The organic light-emitting display device of claim 10, wherein the plurality of connection structures may comprise two or more connection structures configured to branch at a plurality of intersection points between the plurality of first subpixels, the plurality of second subpixels, and the plurality of third subpixels.

### [Advantageous Effects]

The effects of the organic light-emitting display device according to the embodiment are described as follows.

According to at least one of the embodiments, since there is no need to use an FMM, the process can be simplified and the process cost can be reduced.

According to at least one of the embodiments, since there is no need to use an FMM, the EAR within the subpixel can be increased, and the lifespan can be improved.

According to at least one of the embodiments, since an organic light-emitting element is deposited on a large-area substrate in an in-line deposition system, productivity, yield, and material utilization efficiency can be improved.

According to at least one of the embodiments, a plurality of connection structures may be disposed lengthwise along a second direction between a plurality of subpixels in a first direction. Accordingly, the complexity of the process can be reduced by disposing the plurality of connection structures lengthwise in a stripe shape along the second direction and electrically connecting the plurality of connection structures to a power wiring on a non-display region.

According to at least one of the embodiments, the plurality of connection structures may commonly connect two cathode electrodes of the two subpixels adjacent to each other in the first direction to the power wiring. Accordingly, voltage of an input power may be equally applied to the subpixels regardless of a position of a panel, thereby implementing a uniform image quality.

According to at least one of the embodiments, the emission area ratio (EAR) can be increased by sharing one connection structure with at least three or more subpixels, thereby improving the product's lifespan and brightness.

According to at least one of the embodiments, two or more connection structures branching from a plurality of intersection points between the plurality of red subpixels, the plurality of green subpixels, and the plurality of blue subpixels may be disposed. Accordingly, two side portions that contact at least two corners of the cathode electrodes, respectively, of the plurality of subpixels may be electrically connected to a first power wiring. Accordingly, the emission area of each of the plurality of subpixels can be increased and the electrical contact area for the cathode electrode can be increased, so that the product's lifespan and brightness can be improved.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

### [Description of Drawings]

FIG. 1 is a plan view schematically illustrating an organic light-emitting display device according to a first embodiment.
FIG. 2 is a plan view schematically illustrating an organic light-emitting display device according to a second embodiment.
FIG. 3 is a cross-sectional view illustrating an organic light-emitting display device according to a first embodiment.
FIG. 4 is a cross-sectional view illustrating an organic light-emitting display device according to a second embodiment.
FIG. 5 is a cross-sectional view illustrating an organic light-emitting display device according to a third embodiment.
FIG. 6 is a cross-sectional view illustrating an organic light-emitting display device according to a fourth embodiment.
FIG. 7 is a cross-sectional view illustrating an organic light-emitting display device according to a fifth embodiment.
FIG. 8 is a plan view schematically illustrating an organic light-emitting display device according to a third embodiment.
FIG. 9 is a plan view schematically illustrating an organic light-emitting display device according to a fourth embodiment.
FIG. 10 is a plan view schematically illustrating an organic light-emitting display device according to a fifth embodiment.
FIG. 11 is a plan view schematically illustrating an organic light-emitting display device according to a sixth embodiment.
FIG. 12 is a plan view schematically illustrating an organic light-emitting display device according to a seventh embodiment.

The sizes, shapes, dimensions, etc. of elements illustrated in the drawings may differ from actual ones. In addition, even if the same elements are illustrated in different sizes, shapes, dimensions, etc. between the drawings, this is only an example on the drawing, and the same elements have the same sizes, shapes, dimensions, etc. between the drawings.

### [Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there may be directly on the other element or be other intermediate elements therebetween.

Hereinafter, an organic light-emitting display device having a side-by-side structure manufactured using a photolithography process is disclosed. This structure is called Ph-SbS (side-by-side structure by photolithography). By using a photolithography process, there is no need to use an FMM, so that the process can be simplified and the process cost can be reduced. In addition, the EAR within the subpixel can be increased, so that the lifespan can be improved. In addition, since the organic light-emitting element is deposited on a large-area substrate in an in-line deposition system, productivity, yield, and material utilization efficiency can be improved.

Hereinafter, a red subpixel may be named a first subpixel, a green subpixel may be named a second subpixel, and a blue subpixel may be named a third subpixel. In addition, a red organic light-emitting element may be named a first organic light-emitting element, a green organic light-emitting element may be named a second organic light-emitting element, and a blue organic light-emitting element may be named a third organic light-emitting element.

Hereinafter, the organic light-emitting display device is a top-emitting type that displays an image by emitting light toward an upper side of the substrate, but a bottom-emitting type that displays an image by emitting light toward a lower side of the substrate may also be included in the technical concept of the present invention.

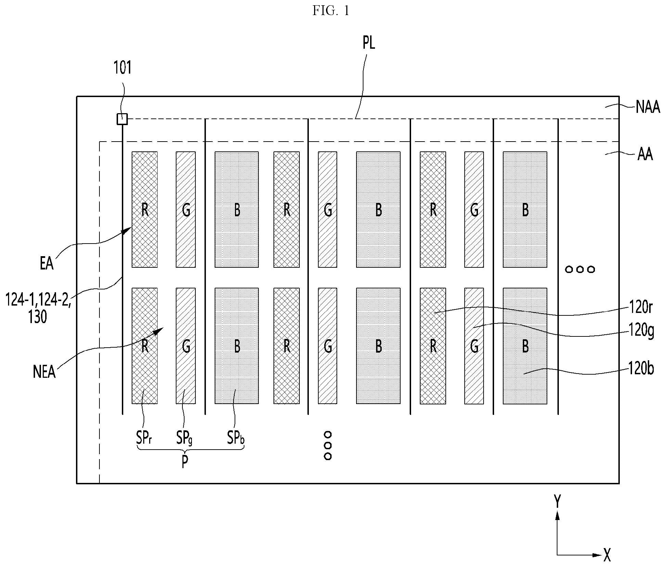

FIG. 1 is a plan view schematically illustrating an organic light-emitting display device according to a first embodiment.

As illustrated in FIG. 1, the organic light-emitting display device according to the first embodiment may comprise a plurality of pixels P arranged in a matrix. The plurality of pixels P may be arranged in a display region AA. The remaining region excluding the display region AA may be defined as a non-display region NAA. The non-display region NAA may be called a bezel region.

The plurality of pixels P may comprise, for example, a plurality of red subpixels SPr, a plurality of green subpixels SPg, a plurality of blue subpixels SPb, etc. The plurality of subpixels SPr, SPg, and SPb may have different colors along a first direction X and may have the same color along a second direction Y intersecting the first direction X, but is not limited thereto. That is, the plurality of subpixels SPr, SPg, and SPb may have a long stripe pattern disposed along the second direction Y with the same color.

The organic light-emitting layer and the cathode electrode of each of the plurality of organic light-emitting elements 120r, 120g, and 120b may have a long stripe pattern disposed along the second direction Y with the same color. For example, the plurality of red subpixels SPr for emitting red light may be arranged in a stripe shape along the second direction Y. For example, the plurality of green subpixels SPg for emitting green light may be arranged in a stripe shape along the second direction Y. For example, the plurality of blue subpixels SPb for emitting blue light may be arranged in a stripe shape along the second direction Y.

The red subpixel SPr, the green subpixel SPg, and the blue subpixel SPb may be alternately arranged in a unit of a column line along the first direction X, so that an organic light-emitting display device having a side-by-side structure may be implemented. For example, the red subpixel SPr, the green subpixel SPg, and the blue subpixel SPb may be alternately arranged in the order of the first direction X, but is not limited thereto.

For example, the red organic light-emitting element 120r may be disposed in the red subpixel SPr, the green organic light-emitting element 120g may be disposed in the green subpixel SPg, and the blue organic light-emitting element 120b may be disposed in the blue subpixel SPb.

For example, the luminescence efficiency of the blue organic light-emitting element 120b may be lower than the luminescence efficiency of the red organic light-emitting element 120r or the green organic light-emitting element 120g. In this instance, an area of the blue subpixel SPb may be designed to be greater than an area of the red subpixel SPr or an area of the green subpixel SPg, so that the lifespans of the red organic light-emitting element 120r, the green organic light-emitting element 120g, and the blue organic light-emitting element 120b can be made uniform, thereby improving the product's brightness.

The plurality of subpixels SPr, SPg, and SPb may each comprise an emission region EA and a non-emission region NEA. The emission region EA is a region where the organic light-emitting elements 120r, 120g, and 120b are disposed, and the non-emission region NEA may be defined as the remaining region excluding the emission region EA.

The red organic light-emitting element 120r, the green organic light-emitting element 120g, and the blue organic light-emitting element 120b may each comprise an anode electrode, an organic light-emitting layer, a cathode electrode, etc. The organic light-emitting layer may comprise a hole injection layer, a hole transport layer, an organic emission layer, an electron transport layer, an electron injection layer, a charge generation layer, etc. The red organic light-emitting element 120r, the green organic light-emitting element 120g, and the blue organic light-emitting element 120b may each comprise at least two or more stack structures. Each stack structure may comprise an organic emission layer that emits light.

The organic light-emitting layer and the cathode electrode may be disposed only in each of the plurality of subpixels SPr, SPg, and SPb along the first direction X. That is, the organic light-emitting layer and the cathode electrode may not be disposed continuously along the first direction X but may be separated from each other. Alternatively, as described above, the organic light-emitting layer and the cathode electrode of each of the plurality of organic light-emitting elements 120r, 120g, and 120b may have a long stripe pattern disposed along the second direction Y with the same color. That is, the organic light-emitting layer and the cathode electrode may be disposed across the plurality of subpixels SPr, SPg, and SPb, respectively, along the second direction Y. That is, the organic light-emitting layer and the cathode electrode may be disposed to connect across the plurality of subpixels SPr, SPg, and SPb, respectively, along the second direction Y, as well as regions between the plurality of subpixels SPr, SPg, and SPb.

Although not illustrated, the organic light-emitting layer and the cathode electrode may be separated into units of at least two or more subpixels or two or more row lines along the second direction Y.

The anode electrode may be disposed only within the plurality of subpixels SPr, SPg, and SPb along the first direction X and the second direction Y. That is, the anode electrode may not be disposed between the plurality of subpixels SPr, SPg, and SPb along the first direction X and the second direction Y. Accordingly, the emission regions EA of the plurality of subpixels SPr, SPg and SPb may be distinguished by the anode electrodes individually provided in the plurality of subpixels SPr, SPg and SPb.

Meanwhile, a power wiring PL may be disposed in the non-display region NAA. The power wiring PL may be provided to supply a first potential voltage to the plurality of subpixels SPr, SPg and SPb. A power terminal 101 may be electrically connected to the power wiring PL, and may supply the first potential voltage supplied from a power supply unit (not illustrated) to the plurality of subpixels SPr, SPg and SPb.

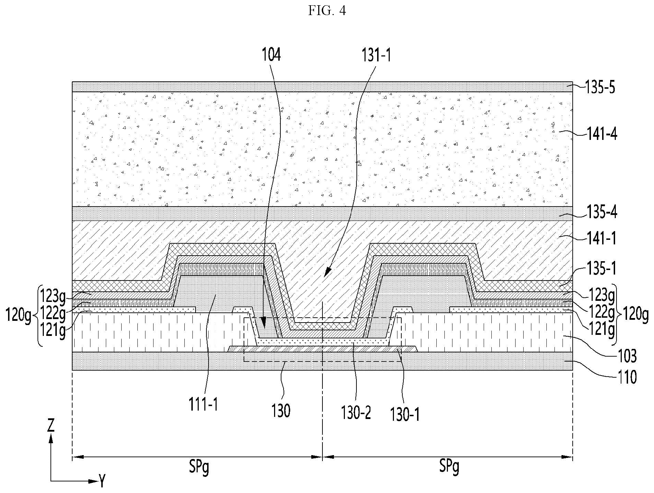

A plurality of connection structures 124-1, 124-2 and 130 may be disposed around the plurality of subpixels SPr, SPg and SPb in the display region AA. The plurality of connection structures 124-1, 124-2 and 130 may be the connection structures 124-1, 124-2 and 130 illustrated in FIGS. 4 to 6. The plurality of connection structures 124-1, 124-2 and 130 may be disposed between the plurality of subpixels SPr, SPg and SPb in the first direction X. The plurality of connection structures 124-1, 124-2 and 130 may be disposed lengthwise along the second direction Y between the plurality of subpixels SPr, SPg and SPb in the first direction X. The plurality of connection structures 124-1, 124-2 and 130 may be disposed in units of two subpixels or two column lines along the first direction X.

The plurality of connection structures 124-1, 124-2 and 130 may be electrically connected to the power wiring by extending from the display region AA to the non-display region NAA. The plurality of connection structures 124-1, 124-2 and 130 may electrically connect the plurality of cathode electrodes of the plurality of organic light-emitting elements 120r, 120g and 120b to the power wiring in the display region AA.

The plurality of connection structures 124-1, 124-2 and 130 may be disposed in units of two subpixels or two column lines along the first direction X. The connection structures 124-1, 124-2 and 130 may be disposed between adjacent subpixels along the second direction Y. In this instance, the adjacent subpixels may share one connection structure 124-1, 124-2 and 130. That is, the green subpixel SPg and the blue subpixel SPb may share one connection structure 124-1, 124-2 and 130, and the red subpixel SPr and the green subpixel SPg may share one connection structure 124-1, 124-2 and 130.

The plurality of connection structures 124-1, 124-2, and 130 may electrically connect a cathode electrode of at least one or more subpixel among two subpixels adjacent in the first direction X to the power wiring PL, respectively. For example, the plurality of connection structures 124-1, 124-2, and 130 may electrically connect a cathode electrode of one subpixel among two subpixels adjacent in the first direction X to the power wiring PL, respectively. For example, the plurality of connection structures 124-1, 124-2, and 130 may commonly connect two cathode electrodes of two subpixels adjacent in the first direction X to the power wiring PL, respectively.

Although not illustrated, another power wiring may be provided to supply a second potential voltage greater than the first potential voltage. Another power wiring may be electrically connected to a driving transistors of each of the subpixels SPr, SPg, and SPb, but is not limited thereto.

The plurality of subpixels SPr, SPg, and SPb may each comprise a driving circuit comprising a driving transistor, etc.

When a specific subpixel is selected by a scan transistor in response to a scan signal, light having luminance corresponding to the current flowing in the driving transistor may be emitted from the specific subpixel by using the first potential voltage of the power wiring PL and the second potential voltage of another power wiring.

Meanwhile, a plurality of waterproof structures, a plurality of open structures, etc. may be disposed between the plurality of subpixels SPr, SPg, and SPb.

The plurality of open structures may be disposed between the plurality of subpixels SPr, SPg, and SPb in the first direction X and/or the second direction Y.

The open structure may be a structure that separates layers comprising low-resistance organic light-emitting materials of each of the organic light-emitting elements 120r, 120g, and 120b, such as a hole injection layer, a charge generation layer, etc., to prevent electrical shorts between the anode electrode and the cathode electrode and reduce leakage current between subpixels.

A transverse leakage current or a longitudinal leakage current between a plurality of subpixels SPr, SPg, and SPb can be prevented by the open structure. The transverse leakage current may be a leakage current flowing between adjacent subpixels SPr, SPg, and SPb along the first direction X, and the longitudinal leakage current may be a leakage current flowing between adjacent subpixels SPr, SPg, and SPb along the second direction Y. In addition, an electrical short between the anode electrode and the cathode electrode in the corresponding subpixels SPr, SPg, and SPb can be prevented by the open structure. Therefore, by using the open structure, color spots due to leakage current can be improved, and the image quality can be improved.

A plurality of waterproof structures may be disposed in the non-display region NAA and the display region AA. For example, a plurality of waterproof structures may be disposed between a plurality of subpixels SPr, SPg, and SPb in the first direction X and/or the second direction Y in the non-display region NAA and the display region AA. A plurality of waterproof structures may be disposed in the non-emission region NEA of each of the plurality of subpixels SPr, SPg, and SPb in the first direction X and/or the second direction Y.

Meanwhile, the organic light-emitting layer, etc. is vulnerable to moisture, oxygen, etc., and when the organic light-emitting layer, etc. is damaged by moisture, oxygen, etc., the corresponding subpixels SPr, SPg, and SPb may not operate, resulting in light-emitting defects. When many subpixels SPr, SPg, and SPb do not operate due to moisture, oxygen, etc., display defects such as point light-emitting defects or region light-emitting defects may occur, which may lower product reliability.

However, a plurality of waterproof structures such as the embodiment can prevent operation defects or light-emitting defects of the plurality of subpixels SPr, SPg, and SPb by preventing moisture, oxygen, etc. from penetrating into the non-display region NAA or the display region AA. Accordingly, the organic light-emitting layers of the subpixels SPr, SPg, and SPb are not affected by moisture, oxygen, etc., so that reliability can be dramatically improved.

According to the embodiment, the plurality of connection structures 124-1, 124-2, and 130 may be disposed lengthwise along the second direction Y between the plurality of subpixels SPr, SPg, and SPb in the first direction X. Accordingly, the complexity of the process can be reduced by disposing the plurality of connection structures 124-1, 124-2, and 130 lengthwise in a stripe shape along the second direction Y and electrically connecting the plurality of connection structures 124-1, 124-2, and 130 to the power wiring PL on the non-display region NAA.

According to the embodiment, the plurality of connection structures 124-1, 124-2 and 130 may commonly connect two cathode electrodes of two subpixels adjacent to each other in the first direction X to the power wiring PL. Accordingly, the voltage of the input power may be equally applied to the subpixels regardless of the position of the panel, thereby implementing a uniform image quality.

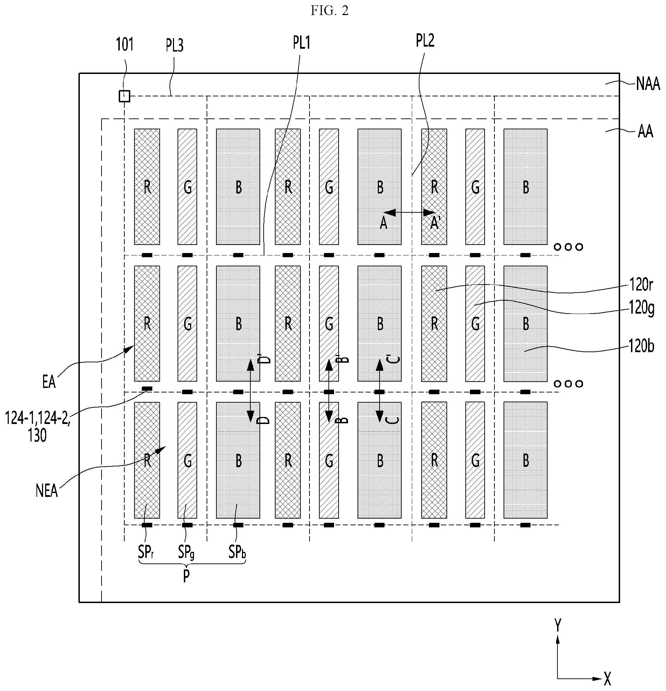

FIG. 2 is a plan view schematically illustrating an organic light-emitting display device according to a second embodiment.

The second embodiment is the same as the first embodiment (FIG. 1) except for the power wiring PL1 to PL3 and the connection structures 124-1, 124-2 and 130. In the second embodiment, the same drawing reference numerals are given to components having the same shape, structure and/or function as those of the first embodiment, and a detailed description thereof is omitted.

As illustrated in FIG. 2, a plurality of power wirings PL1 to PL3 may be provided to supply a first potential voltage to a plurality of subpixels SPr, SPg, and SPb.

The plurality of power wirings PL1 to PL3 may be disposed in a non-display region NAA and a display region AA.

The power wirings PL1 and PL2 may be disposed between the plurality of subpixels SPr, SPg, and SPb in the display region AA, and may be electrically connected to the plurality of subpixels SPr, SPg, and SPb. The power wirings PL1 and PL2 may be electrically connected to a plurality of cathode electrodes of the plurality of organic light-emitting elements 120r, 120g, and 120b provided in the plurality of subpixels SPr, SPg, and SPb through a plurality of connection structures 124-1, 124-2, and 130.

A plurality of first power wiring PL1 and a plurality of second power wiring PL2 may intersect and be connected to each other. The plurality of first power wiring PL1 and the plurality of second power wiring PL2 may have a matrix structure. A third power wiring PL3 may be disposed in a non-display region NAA, and may be electrically connected to, for example, a plurality of second power wiring PL2. The second power wiring PL2 may be omitted. When the second power wiring PL2 is omitted, the first power wiring PL1 may be electrically connected to the third power wiring PL3.

A plurality of connection structures 124-1, 124-2, and 130 may be disposed between a plurality of subpixels SPr, SPg, and SPb in the second direction Y.

The plurality of connection structures 124-1, 124-2 and 130 may electrically connect the second power wiring PL2 disposed between the plurality of subpixels SPr, SPg and SPb in the second direction Y to the plurality of cathode electrodes of the plurality of organic light-emitting elements 120r, 120g and 120b of the plurality of subpixels SPr, SPg and SPb.

The plurality of connection structures 124-1, 124-2 and 130 may be locally formed in a dot shape between the plurality of subpixels SPr, SPg and SPb in the second direction Y.

As an example, the plurality of connection structures 124-1, 124-2 and 130 may be formed in recesses having a dot shape, respectively. A laser ablation process or a laser welding process may be used to electrically connect the first power wiring PL1 to the plurality of cathode electrodes of the plurality of organic light-emitting elements 120r, 120g and 120b in the corresponding recess.

The plurality of connection structures 124-1, 124-2 and 130 may be disposed between the plurality of subpixels SPr, SPg and SPb in the second direction Y, but may be disposed in units of two or more row lines or two or more subpixels along the second direction Y.

In this instance, the number of shots of the laser beam along the second direction Y may vary depending on the size of the panel. That is, the larger the size of the panel, the more the number of shots of the laser beam along the second direction Y may increase. For example, in a panel of 8" or larger, a laser welding process may be performed on connection structures 124-1, 124-2, and 130 of 5 points or more per line of a stripe pattern to improve brightness reduction in a center of the panel. For example, in a panel of 20" or larger, a laser welding process may be performed on connection structures 124-1, 124-2, and 130 of 20 points or more per line of a stripe pattern.

As another example, a plurality of connection structures 124-1, 124-2, and 130 may be formed on the side portions of the protrusion part, respectively. That is, the organic light-emitting layer and the cathode electrode may be deposited at different deposition angles in the undercut structure formed on the side portions of the protrusion part, so that the cathode electrode may be electrically connected to the auxiliary electrode included in the protrusion part.

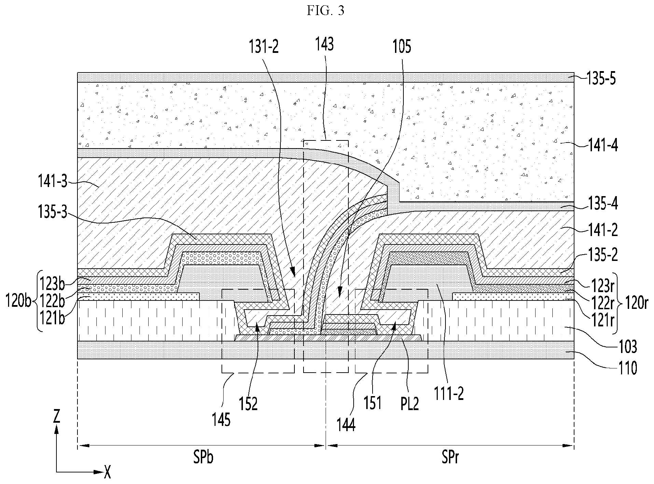

FIG. 3 is a cross-sectional view illustrating an organic light-emitting display device according to a first embodiment. FIG. 3 may be a cross-sectional view taken along line A-A' in FIG. 2. FIG. 4 is a cross-sectional view showing an organic light-emitting display device according to a second embodiment. FIG. 4 is an example of a cross-sectional view taken along line B-B' in FIG. 2.

As shown in FIGS. 2 to 4, the organic light-emitting display device according to the embodiment may comprise a plurality of banks 111-1 and 111-2, a plurality of power wirings PL1 to PL3, a plurality of organic light-emitting elements 120r, 120g, and 120b, a plurality of connection structures 130, etc.

The plurality of banks 111-1 and 111-2, the plurality of power wirings PL1 to PL3, the plurality of organic light-emitting elements 120r, 120g, and 120b, and the plurality of connection structures 130 may be disposed on the substrate 110.

An interlayer insulating layer 103 may be disposed on a substrate 110, and a plurality of banks 111-1 and 111-2, a plurality of organic light-emitting elements 120r, 120g, and 120b, and a plurality of connection structures 130 may be disposed on the interlayer insulating layer 103.

A plurality of driving circuits may be formed on the substrate 110. The plurality of driving circuits may be provided in the plurality of subpixels SPr, SPg, and SPb, respectively. The plurality of driving circuits may comprise a plurality of transistors, at least one or more capacitor, etc. The plurality of transistors may comprise a scan transistor, a driving transistor, a sensing transistor, etc.

The interlayer insulating layer 103 may be disposed on the plurality of driving circuits. The interlayer insulating layer 103 may be a planarization layer. To this end, an upper surface of the interlayer insulating layer 103 may have a flat surface.

The plurality of banks 111-1 and 111-2 may be disposed between the plurality of subpixels SPr, SPg, and SPb.

The plurality of banks may comprise a plurality of first banks 111-1 and a plurality of second banks 111-2. The first banks 111-1 and the second banks 111-2 may intersect and be connected to each other. The plurality of first banks 111-1 and the plurality of second banks 111-2 may have a matrix structure.

The plurality of first banks 111-1 may be disposed to correspond to a plurality of first power wiring PL1, and the plurality of second banks 111-2 may be disposed to correspond to a plurality of second power wiring PL2. That is, the plurality of first banks 111-1 may be disposed on a plurality of first power wiring PL1, and the plurality of second banks 111-2 may be disposed on a plurality of second power wiring PL2.

The plurality of first banks 111-1 may be disposed between the plurality of subpixels SPr, SPg, and SPb in the second direction Y, and the plurality of second banks 111-2 may be disposed between the plurality of subpixels SPr, SPg, and SPb in the first direction X. The plurality of first banks 111-1 may be disposed lengthwise along the first direction X between the plurality of subpixels SPr, SPg, and SPb in the second direction Y, and the plurality of second banks 111-2 may be disposed lengthwise along the second direction Y between the plurality of subpixels SPr, SPg, and SPb in the first direction X.

As an example, the plurality of emission regions EA may be separated by the plurality of first banks 111-1 and the plurality of second banks 111-2. The plurality of emission regions EA may be surrounded by the plurality of first banks 111-1 and the plurality of second banks 111-2.

As another example, a plurality of emission regions EA may be separated by a plurality of anode electrodes 121r, 121g, and 121b individually provided in a plurality of subpixels SPr, SPg, and SPb. The plurality of anode electrodes 121r, 121g, and 121b may be disposed only within the plurality of subpixels SPr, SPg, and SPb, and are not disposed between the plurality of subpixels SPr, SPg, and SPb.

As another example, the emission region EA may be defined by the organic light-emitting layers 122r, 122g, and 122b exposed by the first bank 111-1 and the second bank 111-2. Since the organic light-emitting layers 122r, 122g and 122b emit light as much as the area of the exposed organic light-emitting layers 122r, 122g and 122b, the emission region EA may be defined by the first bank 111-1 and the second bank 111-2.

The plurality of subpixels SPr, SPg and SPb may each comprise the emission region EA and the non-emission region NEA. The regions corresponding to the banks 111-1 and 111-2 may be defined as the non-emission region NEA. In this instance, the banks 111-1 and 111-2 may be shared by the adjacent subpixels SPr, SPg and SPb. That is, parts of the banks 111-1 and 111-2 may be included in one subpixel, and other parts of the banks 111-1 and 111-2 may be included in another subpixel adjacent to one subpixel.

The plurality of organic light-emitting elements 120r, 120g and 120b may be disposed in the plurality of subpixels SPr, SPg and SPb, respectively. The plurality of organic light-emitting elements 120r, 120g and 120b may comprise a plurality of anode electrodes 121r, 121g and 121b, a plurality of organic light-emitting layers 122r, 122g and 122b, and a plurality of cathode electrodes 123r, 123g and 123b.

The anode electrodes 121r, 121g, and 121b may be disposed only in the subpixels SPr, SPg, and SPb along the first direction X and the second direction Y. The red anode electrode 121r may be disposed only in the plurality of red subpixels SPr along the second direction Y, the green anode electrode 121g may be disposed only in the plurality of green subpixels SPg along the second direction Y, and the blue anode electrode 121b may be disposed only in the plurality of blue subpixels SPb along the second direction Y.

The organic light-emitting layers 122r, 122g, and 122b may be disposed separately from each other along the first direction X, but continuously along the second direction Y. The red organic light-emitting layer 122r may be disposed continuously in the plurality of red subpixels SPr as well as the plurality of first banks 111-1 along the second direction Y. The green organic light-emitting layer 122g may be disposed continuously in a plurality of green subpixels SPg as well as a plurality of first banks 111-1 along the second direction Y. The blue organic light-emitting layer 122b may be disposed continuously in a plurality of subpixels SPr, SPg, and SPb as well as a plurality of first banks 111-1 along the second direction Y. The red organic light-emitting layer 122r, the green organic light-emitting layer 122g, and the blue organic light-emitting layer 122b may be referred to as a first organic light-emitting layer, a second organic light-emitting layer, and a third organic light-emitting layer, respectively.

The cathode electrodes 123r, 123g, and 123b may be disposed separately from each other along the first direction X, but may be disposed continuously along the second direction Y. The red cathode electrode 123r may be disposed continuously in the plurality of subpixels SPr, SPg, and SPb as well as the plurality of first banks 111-1 along the second direction Y. The green cathode electrode 123g may be disposed continuously in the plurality of green subpixels SPg as well as the plurality of first banks 111-1 along the second direction Y. The blue cathode electrode 123b may be disposed continuously in the plurality of subpixels SPr, SPg, and SPb as well as the plurality of first banks 111-1 along the second direction Y. The red cathode electrode 123r, the green cathode electrode 123g, and the blue cathode electrode 123b may be referred to as a first cathode electrode, a second cathode electrode, and a third cathode electrode, respectively.

The plurality of connection structures 130 may be disposed in the plurality of first banks 111-1. Although the drawing illustrates that the connection structure 130 is disposed in all of the plurality of first banks 111-1, it may not be disposed in all of the plurality of first banks 111-1. That is, the connection structure 130 may be disposed in some of the plurality of first banks 111-1.

The plurality of first banks 111-1 may have a plurality of first recesses 131-1. The first recess 131-1 may be locally formed in a part of the first bank 111-1 between the plurality of subpixels SPr, SPg, and SPb in the second direction Y. The first recess 131-1 may have a circular or rectangular shape when viewed from above, but is not limited thereto. The first recess 131-1 may be formed by penetrating from an upper surface to a lower surface at a center of the first bank 111-1, but are not limited thereto.

As illustrated in FIG. 4, the connection structure 130 may be disposed in the first recess 131-1 of the first bank 111-1. The connection structure 130 may electrically connect the green cathode electrode 123g to a first power wiring PL1 in the first recess 131-1 of the first bank 111-1.

The connection structure 130 may comprise a lower electrode 130-1 and an upper electrode 130-2.

The lower electrode 130-1 may be formed by extending from the first power wiring PL1. In the first power wiring PL1 disposed lengthwise along the first direction X, the first power wiring PL1 corresponding to the first recess 131-1 of the first bank 111-1 may be formed as the lower electrode 130-1. Accordingly, the lower electrode 130-1 may be a part of the first power wiring PL1. A width of the lower electrode 130-1 may be greater than a width of the first power wiring PL1, but is not limited thereto.

The upper electrode 130-2 may be disposed on the lower electrode 130-1. A lower surface of the upper electrode 130-2 may be in contact with an upper surface of the lower electrode 130-1. The upper electrode 130-2 may comprise the same material as the green anode electrode 121g.

The green cathode electrode 123g may be electrically connected to the first power wiring PL1 through the connection structure 130. To this end, the green cathode electrode 123g may be in contact with an upper surface of the upper electrode 130-2 of the connection structure 130.

A first recess 104 may be formed in the interlayer insulating layer 103 corresponding to the first recess 131-1 of the first bank 111-1. The lower electrode 130-1 may be exposed by the first recess 104 of the interlayer insulating layer 103, and the upper electrode 130-2 may be disposed on the exposed lower electrode 130-1. In addition, the upper electrode 130-2 may be exposed by the first recess 131-1 of the first bank 111-1, and the green cathode electrode 123g may be disposed on the exposed upper electrode 130-2.

After a green organic light-emitting layer 122g is deposited on the upper electrode 130-2, the green organic light-emitting layer 122g may be removed to expose the upper electrode 130-2, and a green cathode electrode 123g may be formed on the exposed upper electrode 130-2. When the green organic light-emitting layer 122g is not completely removed, non-removed particles of the green organic light-emitting layer 122g, i.e., residual particles or lumps, may be disposed on the upper surface of the upper electrode 130-2. In this instance, the green cathode electrode 123g may be in contact with the upper surface of the upper electrode 130-2 of the connection structure 130 through the residual particles or lumps.

Meanwhile, although not illustrated, the first recesses 131-1 and 104 are not formed in the remaining regions except for the connection structure 130 between the plurality of green subpixels SPg in the second direction Y. That is, since the first recesses 131-1 and 104 are not formed in the interlayer insulating layer 103 and the first bank 111-1, the upper surface of the interlayer insulating layer 103 and the upper surface of the first bank 111-1 may have a flat surface, respectively. Accordingly, the green organic light-emitting layer 122g, the green cathode electrode 123g, etc. on the first bank 111-1 may be formed to be continuously connected to the adjacent green subpixel SPg without interruption.

Meanwhile, a plurality of second banks 111-2 may be disposed between a plurality of subpixels SPr, SPg, and SPb in the first direction X. The plurality of second banks 111-2 may be disposed lengthwise along the second direction Y. A plurality of second recesses 131-2 may be formed in the plurality of second banks 111-2. The plurality of second recesses 131-2 may be formed lengthwise along the second direction Y. The second recesses 131-2 may be formed to penetrate from an upper surface to a lower surface at a center of the second bank 111-2, but are not limited thereto.

A second recesses 105 may also be formed in the interlayer insulating layer 103 corresponding to the second recesses 131-2 of the second bank 111-2. A second power wiring PL2 may be exposed by the second recesses 105 of the interlayer insulating layer 103.

Meanwhile, as illustrated in FIGS. 2 to 4, the organic light-emitting display device according to the embodiment may comprise a plurality of inorganic insulating layers 135-1 to 135-5, a plurality of organic insulating layers 141-1 to 141-4, a plurality of waterproof structures 143, 144, and 145, etc.

The plurality of inorganic insulating layers may comprise a first inorganic insulating layer 135-1, a second inorganic insulating layer 135-2, a third inorganic insulating layer 135-3, a fourth inorganic insulating layer 135-4, and a fifth inorganic insulating layer 135-5. The first inorganic insulating layer 135-1, the second inorganic insulating layer 135-2, the third inorganic insulating layer 135-3, the fourth inorganic insulating layer 135-4, and the fifth inorganic insulating layer 135-5 may each comprise at least one or more inorganic insulating film.

The first inorganic insulating layer 135-1 may be disposed on the green cathode electrode 123g of the green organic light-emitting element 120g in the green subpixel SPg, the second inorganic insulating layer 135-2 may be disposed on the red cathode electrode 123r of the red organic light-emitting element 120r in the red subpixel SPr, and the third inorganic insulating layer 135-3 may be disposed on the blue cathode electrode 123b of the blue organic light-emitting element 120b in the blue subpixel SPb.

The first inorganic insulating layer 135-1, the second inorganic insulating layer 135-2, and the third inorganic insulating layer 135-3 may each be configured as a double layer comprising a silicon oxide layer and a silicon nitride layer. The silicon nitride layer may be disposed on the silicon oxide layer. For example, the silicon oxide layer may be formed using an atomic layer deposition (ALD) process, and the silicon nitride layer may be formed using a chemical vapor deposition (CVD) process.

The fourth inorganic insulating layer 135-4 and the fifth inorganic insulating layer 135-5 may be disposed on the entire region of the substrate 110. The fourth inorganic insulating layer 135-4 and the fifth inorganic insulating layer 135-5 may be formed using a PECVD process as a silicon nitride series, but is not limited thereto. At least one or more of the fourth inorganic insulating layer 135-4 and the fifth inorganic insulating layer 135-5 may be omitted.

Therefore, by disposing a plurality of inorganic insulating layers 135-1 to 135-5 on each of the plurality of subpixels SPr, SPg, and SPb or on the entire region of the substrate 110, penetration of moisture, oxygen, etc. can be completely blocked.

The plurality of organic insulating layers may comprise a first organic insulating layer 141-1, a second organic insulating layer 141-2, a third organic insulating layer 141-3, and a fourth organic insulating layer 141-4.

The first organic insulating layer 141-1 may be disposed on the first inorganic insulating layer 135-1 in the green subpixel SPg, the second organic insulating layer 141-2 may be disposed on the second inorganic insulating layer 135-2 in the red subpixel SPr, and the third organic insulating layer 141-3 may be disposed on the third inorganic insulating layer 135-3 in the blue subpixel SPb.

The fourth organic insulating layer 141-4 may be disposed on the fifth inorganic insulating layer 135-5 formed on the entire region of the substrate 110.

The first organic insulating layer 141-1, the second organic insulating layer 141-2, and the third organic insulating layer 141-3 may be used as a color filter layer, respectively. In this instance, the first organic insulating layer 141-1, the second organic insulating layer 141-2, and the third organic insulating layer 141-3 may transmit only light of a specific wavelength band from light emitted from the red organic light-emitting element 120r, the green organic light-emitting element 120g, and the blue organic light-emitting element 120b, respectively.

The first organic insulating layer 141-1, the second organic insulating layer 141-2, and the third organic insulating layer 141-3 may be used as a photosensitive pattern, respectively. In this instance, there is no need to form a separate photosensitive pattern on the first organic insulating layer 141-1, the second organic insulating layer 141-2, and the third organic insulating layer 141-3.

The first organic insulating layer 141-1, the second organic insulating layer 141-2, and the third organic insulating layer 141-3 may be omitted, or the fourth organic insulating layer 141-4 may be omitted.

Meanwhile, the plurality of waterproof structures 143, 144, and 145 may be disposed in the second bank 111-2 positioned between the plurality of subpixels SPr, SPg, and SPb in the first direction X. The plurality of waterproof structures 143, 144, and 145 may be disposed in the second recess 131-2 of the second bank 111-2.

The plurality of waterproof structures may comprise a first waterproof structure 143, a second waterproof structure 144, a third waterproof structure 145, etc.

By disposing a plurality of waterproof structures, namely, a first waterproof structure 143, a second waterproof structure 144, and a third waterproof structure 145, in the second recess 131-2 of the second bank 111-2, penetration of moisture, oxygen, etc. can be completely blocked.

The first waterproof structure 143 may be configured by overlapping two or more inorganic insulating layers among the plurality of inorganic insulating layers 135-1 to 135-5 on the second bank 111-2.

As illustrated in FIG. 3, the second inorganic insulating layer 135-2 and the third inorganic insulating layer 135-3 may be overlapping on the second recess 131-2 of the second bank 111-2, which is disposed between the red subpixel SPr and the blue subpixel SPb, so that the first waterproof structure 143 may be configured. For example, the third inorganic insulating layer 135-3 may be disposed on the second inorganic insulating layer 135-2.

The second organic insulating layer 141-2 may be disposed between the third inorganic insulating layer 135-3 and the second inorganic insulating layer 135-2. In this instance, the second organic insulating layer 141-2 may have a round surface. Accordingly, the third inorganic insulating layers 135-3 disposed on the second organic insulating layer 141-2 may have a round surface.

The fourth organic insulating layer 141-4 may be a planarization layer in which an upper surface has a flat surface.

As illustrated in FIG. 3, a plurality of second power wiring PL2 may be disposed under the plurality of second banks 111-2. The plurality of second power wiring PL2 may be exposed by a plurality of second recesses 131-2 of the plurality of second banks 111-2. A first waterproof structure 143 in which at least two or more inorganic insulating layers among a plurality of inorganic insulating layers 135-1 to 135-5 are overlapped may be positioned on each of the plurality of second power wiring PL2.

The second power wiring PL2 may be provided to prevent the interlayer insulating layer 103 from being excessively etched when the interlayer insulating layer 103 under the second bank 111-2 is removed to form the first undercut structure 151 and the second undercut structure 152. When there is no concern that the interlayer insulating layer 103 will be excessively etched, the second power wiring PL2 may be omitted.

Meanwhile, the second waterproof structure 144 may be configured by forming one inorganic insulating layer among the plurality of inorganic insulating layers 135-1 to 135-5 in a curved shape by the first undercut structure 151. The third waterproof structure 145 may be configured by forming another inorganic insulating layer among the plurality of inorganic insulating layers 135-1 to 135-5 in a curved shape by the second undercut structure 152.

The first undercut structure 151 and the second undercut structure 152 may be formed on a lower side of the second bank 111-2 that contacts the second recess 131-2 of the second bank 111-2. The first undercut structure 151 and the second undercut structure 152 may be formed by removing the interlayer insulating layer 103 positioned on the lower side of the second bank 111-2 that contacts the second recess 131-2 of the second bank 111-2. That is, the side portions of the interlayer insulation layer 103 may be recessed from the inner side portion of the second bank 111-2, which is in contact with the second recess 131-2 of the second bank 111-2, in a direction of an outer side, so that the first undercut structure 151 and the second undercut structure 152 may be formed.

As illustrated in FIG. 3, the second inorganic insulating layer 135-2 may be formed in a curved shape by the first undercut structure 151 to form the second waterproof structure 144. The second inorganic insulating layer 135-2 may be disposed on the lower side of the second bank 111-2 and the side portions of the interlayer insulating layer 103, which contacts the second recess 131-2 by the first undercut structure 151, so that the second waterproof structure 144 may be formed in a curved shape. Since the second inorganic insulating layer 135-2 is formed in a curved shape, the penetration path of moisture, oxygen, etc. may be maximized, so that the waterproofing characteristics can be improved.

The third inorganic insulating layer 135-3 may be formed in a curved shape by the second undercut structure 152 of the second bank 111-2, so that the third waterproof structure 145 may be configured. The third inorganic insulating layer 135-3 may be disposed on the lower side of the second bank 111-2 and the side portions of the interlayer insulating layer 103, which contacts the second recess 131-2 by the second undercut structure 152, so that the third waterproof structure 145 may be formed in a curved shape. Since the third inorganic insulating layer 135-3 is formed in a curved shape, the penetration path of moisture, oxygen, etc. may be maximized, so that the waterproofing characteristics can be improved.

In addition, although the waterproof structures 143 to 145 of FIG. 3 have been described in detail, the waterproof structures 143 to 145 of FIG. 3 may not be formed or comprised. That is, the arrangement of the connection structures 124-1, 124-2, and 130 of FIG. 2 may also be possible without the waterproof structures 143 to 145.

For example, in the process of patterning each subpixel SPr, SPg, and SPb, when all patterning processes after the photolithography process (development process) are performed in a dry manner, there is no wet etching, stripping, or wet cleaning, so that the waterproof structure 143 to 145 as in FIG. 3 may not be comprised.

Meanwhile, although not illustrated, the open structure may be formed in an edge region of the lower side of the first bank 111-1 and/or the second bank 111-2. The undercut structure may be formed in the edge region of the lower side of the first bank 111-1 and/or the second bank 111-2. In this instance, the open structure may be formed by the undercut structure.

According to the embodiment, the connection structure 130 may be disposed in the first recess 131-1 of the plurality of first banks 111-1 between the plurality of subpixels SPr, SPg, and SPb having the same color in the second direction Y. Accordingly, electrical connection between the cathode electrodes 123r, 123g, and 123b of the plurality of subpixels SPr, SPg, and SPb and the first power wiring PL1 can be facilitated, and a disconnection defect can be prevented, so that operation defects or light-emitting defects of the subpixels SPr, SPg, and SPb can be prevented, thereby improving reliability. In particular, by grouping the plurality of subpixels SPr, SPg, and SPb along the second direction Y and disposing the connection structure 130 between the grouped subpixels, the number of shots of the laser beam can be drastically reduced when using the laser ablation process to be described later, so that the process time or process cost can be reduced.

According to the embodiment, since a plurality of waterproof structures 143, 144, and 145 are disposed in each of the plurality of second banks 111-2, moisture, oxygen, etc. penetrating along the second direction Y may not penetrate into the plurality of subpixels SPr, SPg, and SPb. Accordingly, operation defects or light-emitting defects of the subpixels SPr, SPg, and SPb can be prevented, thereby improving reliability.

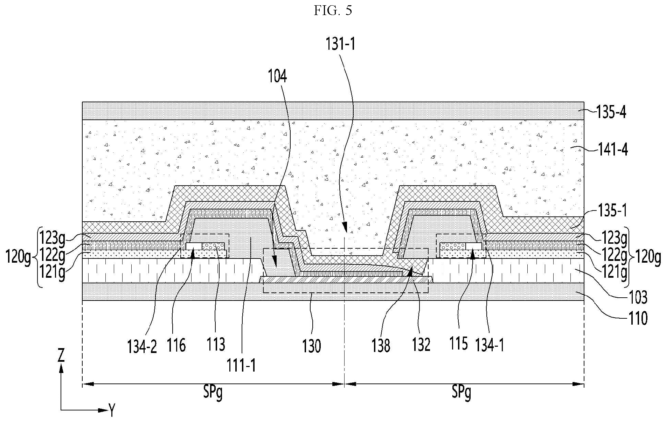

FIG. 5 is a cross-sectional view illustrating an organic light-emitting display device according to a third embodiment. FIG. 5 is another example of a cross-sectional view cut along the line B-B' in FIG. 2.

The third embodiment is the same as the second embodiment (FIG. 4) except for the connection structure 130. In the third embodiment, the same drawing reference numerals are given to components having the same shape, structure, and/or function as those of the second embodiment, and detailed descriptions are omitted.

As illustrated in FIG. 5, a plurality of connection structures 130 may be disposed in a plurality of first banks 111-1.

The connection structure 130 may be disposed in the first recess 131-1 of the first bank 111-1. The connection structure 130 may electrically connect the green cathode electrode 123g to the first power wiring (PL1 of FIG. 1) in the first recess 131-1 of the first bank 111-1.

The green organic light-emitting layer 122g and the green cathode electrode 123g may be disposed across the first bank 111-1 along the second direction Y. In this instance, the green organic light-emitting layer 122g and the green cathode electrode 123g may be separated from the first recess 131-1 of the first bank 111-1, respectively. That is, the green organic light-emitting layer 122g on the upper side of the first bank 111-1 and the green organic light-emitting layer 122g in the first recess 131-1 may be separated from each other. The green cathode electrode 123g on the upper side of the first bank 111-1 and the green cathode electrode 123g in the first recess 131-1 may be separated from each other. In this instance, the green cathode electrode 123g may be electrically connected to the connection structure 130 through the separated green organic light-emitting layer 122g in the first recess 131-1.

Although not illustrated, the red cathode electrode 123r and the blue cathode electrode may be electrically connected to the connection structure 130 in the first recess 131-1, respectively.

The undercut structure 138 may be formed on the lower side of the first bank 111-1 that contacts the first recess 131-1. For example, the undercut structure 138 may be formed so that the side portions of the interlayer insulating layer 103 that contacts the first recess 131-1 may be recessed from the inner side portion of the first bank 111-1 in a direction of outer side.

The connection structure 130 may comprise an auxiliary electrode 132 that extends from the first power wire PL1. In the first power wire PL1 that are disposed lengthwise along the first direction X, the first power wire PL1 corresponding to the first recess 131-1 of the first bank 111-1 may be formed as the auxiliary electrode 132. Accordingly, the auxiliary electrode 132 may be a part of the first power wire PL1. The width of the auxiliary electrode 132 may be greater than the width of the first power wire PL1, but is not limited thereto.

Although FIG. 5 illustrates a plurality of connection structures 130 disposed between a plurality of green subpixels SPg in the second direction Y, a plurality of connection structures 130 disposed between a plurality of red subpixels SPr in the second direction Y and a plurality of connection structures between a plurality of blue subpixels SPb in the second direction Y may also be identical to a plurality of connection structures disposed between a plurality of green subpixels SPg.

Since the green organic light-emitting layer 122g is cut off by the undercut structure 138, a part of the auxiliary electrode 132 may be exposed. Accordingly, the green cathode electrode 123g may be in contact with a part of the exposed auxiliary electrode 132 in the undercut structure 138. In other words, the green cathode electrode 123g may be electrically connected to the first power wiring PL1 through the connection structure 130.

Since the undercut structure 138 cut offs the green organic light-emitting layer 122g and contacts the green cathode electrode 123g with the auxiliary electrode 132, the undercut structure 138 may also be included in the connection structure 130, but is not limited thereto.

The interlayer insulating layer 103 may have a first recess 104 corresponding to the first recess 131-1 of the first bank 111-1. The first recess 104 of the interlayer insulating layer 103 may be formed between a plurality of green subpixels SPg in the second direction Y, corresponding to the first recess 131-1 of the first bank 111-1.

The undercut structure 138 may be in contact with the first recess 131-1 of the first bank 111-1 and the first recess 104 of the interlayer insulating layer 103. In this instance, the auxiliary electrode 132 of the connection structure 130 may be exposed in the undercut structure 138, and the green cathode electrode 123g may be in contact with a part of the exposed auxiliary electrode 132.

Meanwhile, the open structures 134-1 and 134-2 may be formed by the undercut structures 115 and 116 formed in an edge region of the lower side of the first bank 111-1.

The open structures 134-1 and 134-2 may comprise at least one or more blocking layer 113 for forming the undercut structures 115 and 116 that is recessed inwardly from the side portions of the first bank 111-1. The undercut structures 115 and 116 formed by the blocking layer 113 that are recessed inwardly from the side portions of the first bank 111-1 may be formed as the open structures 134-1 and 134-2. The blocking layer 113 may comprise a silicon-based inorganic material, a metal, etc. As the metal, aluminum (Al), molybdenum (Mo), a molybdenum alloy, etc. may be used, but are not limited thereto.

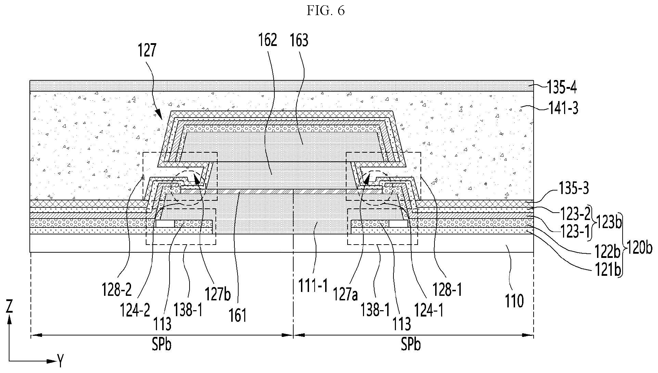

Although not illustrated in FIG. 6, the open structures 134-1 and 134-2 may be disposed in an edge region of the second bank 111-2. The open structures 134-1 and 134-2 may be disposed in an edge region of the second bank 111-2 between a plurality of subpixels SPr, SPg, and SPb in the first direction X or an edge region of the first bank 111-1 between a plurality of subpixels SPr, SPg, and SPb in the second direction Y.

According to the embodiment, since the hole injection layer, charge generation layer, etc. of each of the plurality of subpixels SPr, SPg, and SPb are cut off by the open structures 134-1 and 134-2, the leakage current flowing to the hole injection layer, charge generation layer, etc. can be blocked, so that the poor image quality can be prevented.

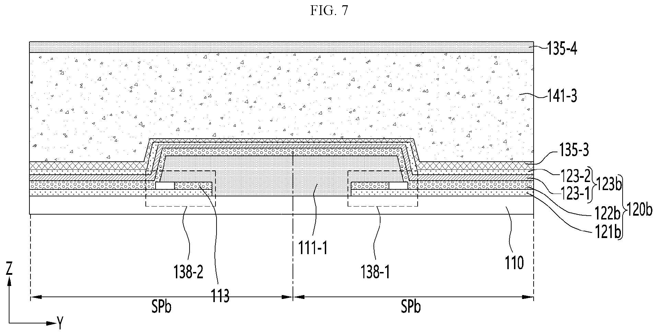

FIG. 6 is a cross-sectional view illustrating an organic light-emitting display device according to a fourth embodiment. FIG. 7 is a cross-sectional view illustrating an organic light-emitting display device according to a fifth embodiment. Figs. 6 and 7 may be cross-sectional views cut along the C-C' line and the D-D' line in FIG. 2, respectively.

The fourth embodiment and the fifth embodiment are similar to the first embodiment (FIG. 3), the second embodiment (FIG. 4), and the third embodiment (FIG. 5) except for the protrusion part 127, the plurality of connection structures 124-1 and 124-2, and the plurality of waterproof structures 128-1 and 128-2. In the fourth embodiment and the fifth embodiment, the same drawing reference numerals are given to components having the same shape, structure, and/or function as those of the first embodiment (FIG. 3), the second embodiment (FIG. 4), and/or the third embodiment (FIG. 5), and a detailed description thereof is omitted.

Although not illustrated, regions between a plurality of red subpixels SPr in the second direction Y and regions between a plurality of green subpixels SPg in the second direction Y may also have the same structure as regions between a plurality of blue subpixels SPb in the second direction Y illustrated in FIGS. 6 and 7.

As shown in FIGS. 2, 6 and 7, the organic light-emitting display device according to the embodiment may comprise a plurality of protrusion parts 127.

The plurality of protrusion parts 127 may be disposed on upper sides of the plurality of first banks 111-1. The plurality of protrusion parts 127 may be disposed on the upper sides of the plurality of first banks 111-1 between the plurality of blue subpixels SPb in the second direction Y. Although not illustrated, the plurality of protrusion parts 127 may also be disposed between the plurality of subpixels SPr, SPg, and SPb in the first direction X, but is not limited thereto.

The left side and the right side of the protrusion part 127 may have shapes that are symmetrical with respect to a center normal of the protrusion part 127, but is not limited thereto. For example, the left side and the right side of the protrusion part 127 may each have an undercut structure. In this instance, the undercut structure on the left side and the undercut structure on the right side may have shapes that are symmetrical with respect to the center normal of the protrusion part 127.

The protrusion part 127 may comprise a floor layer 161, a pillar layer 162 on the floor layer 161, and a roof layer 163 on the pillar layer 162.

The floor layer 161 may comprise, for example, a metal having excellent electrical conductivity or a conductive oxide material. Therefore, the floor layer 161 may be an auxiliary electrode connected to the second power wiring PL2. The blue cathode electrode 123b may be electrically connected to a part of the floor layer 161 and/or the pillar layer 162.

The floor layer 161 may comprise a material having a low etching rate. For example, the etching rate of the floor layer 161 may be lower than the etching rate of the pillar layer 162.

Undercut structures 127a and 127b may be formed by the floor layer 161, the pillar layer 162, and the roof layer 163. That is, undercut structures 127a and 127b may be formed in which the side portions of the pillar layer 162 are recessed inwardly from the side portions of the floor layer 161 and/or the side portions of the roof layer 163 in a direction of an inner side of the protrusion part 127.

The undercut structures 127a and 127b may have a cave shape, respectively. For example, the undercut structures 127a and 127b may have a U-cave shape. Accordingly, the undercut structures 127a and 127b may be called a cave, a U-shaped cave, a cave part, etc. In order to form the undercut structures 127a and 127b, the pillar layer 162 may have different etching selectivity from the floor layer 161 and/or the roof layer 163. For example, the pillar layer 162 may comprise a material having a high etching rate, and the floor layer 161 and/or the roof layer 163 may comprise a material having a low etching rate. Accordingly, when the floor layer 161, the pillar layer 162, and the roof layer 163 are etched after a photosensitive pattern is formed on the roof layer 163, the side portions of the pillar layer 162 may be etched faster than the side portions of the floor layer 161 and/or the roof layer 163, so that undercut structures 127a and 127b may be formed on the side portions of the protrusion part 127.

The pillar layer 162 may be made of a metal, a conductive oxide material, an insulating material, etc. As the metal, titanium (Ti), molybdenum (Mo), molybdenum-titanium (MoTi), aluminum (Al), copper (Cu), and alloys thereof may be used. As the conductive oxide material, ITO, IZO, etc., may be used. As the insulating material, a silicon oxide series material or a silicon nitride series material may be used.

Meanwhile, by adjusting a target-source distance of the evaporation source (or the evaporation source device), the deposition material may be deposited on the substrate 110 at different deposition angles. The target-source distance may be a distance between the evaporation source and the substrate 110. The deposition angle may be the angle of a virtual line between the evaporation source and a lower edge of the roof layer 163 with respect to a normal direction. For example, the deposition angle may be reduced as the target-source distance increases. As the deposition angle decreases, the layer formed by the deposition material may be deposited closer to the adjacent subpixel. As the deposition angle increases, the layer may be deposited closer to the protrusion part 127.

As illustrated in FIG. 6, since the deposition materials are deposited at different deposition angles, one end of the blue organic light-emitting layer 122b and one end of the first conductive layer 123-1 of the blue cathode electrode 123b may be positioned differently from each other.

The blue cathode electrode 123b may comprise a plurality of conductive layers 123-1 and 123-2. For example, the blue cathode electrode 123b may comprise a first conductive layer 123-1 and a second conductive layer 123-2 on the first conductive layer 123-1, but three or more conductive layers may be also included.

One end of the blue organic light-emitting layer 122b and one end of the first conductive layer 123-1 may be positioned on the upper side of the first bank 111-1. For example, one end of the blue organic light-emitting layer 122b may be positioned closer to the pillar layer 162 than one end of the first conductive layer 123-1.

The second conductive layer 123-2 may be disposed on the entire region of the substrate 110. The second conductive layer 123-2 may be deposited using a sputtering process. That is, the second conductive layer 123-2 may be disposed on the upper side of the first conductive layer 123-1 of each of the subpixels SPr, SPg, and SPb, the upper side of the first bank 111-1, and the side portion and upper side of the protrusion part 127. The second conductive layer 123-2 may be in contact with the side portions of the pillar layer 162 and/or the lower side of the roof layer 163.

For example, the first conductive layer 123-1 may comprise a metal having excellent electrical conductivity, and the second conductive layer 123-2 may comprise a conductive oxide material. For example, the first conductive layer 123-1 may comprise a Mg:Ag alloy, and the second conductive layer 123-2 may comprise ITO, IZO, etc.

The metal alloy, i.e., Mg:Ag alloy may form a first conductive layer 123-1 through deposition using an evaporation source. However, since the step coverage characteristics of Mg:Ag are not good, it is difficult for the deposition material comprising the Mg:Ag alloy to be deposited deep inside the undercut structure of the connection structures 124-1 and 124-2. In addition, when the film thickness uniformity of the first conductive layer 123-1 comprising the Mg:Ag alloy is insufficient or the process margin is insufficient, the first conductive layer 123-1 may not be electrically connected to the auxiliary electrodes included in the connection structures 124-1 and 124-2, resulting in poor electrical connection.

To solve this problem, a conductive oxide material such as ITO having excellent step coverage characteristics may be deposited on the substrate 110 using a sputtering process, so that it may be deposited deep inside the undercut structure of the connection structures 124-1 and 124-2. Accordingly, the second conductive layer 123-2 may be stably deposited on the side portions of the pillar layer 162, which is the auxiliary electrode, so that poor electrical connection between the blue cathode electrode 123b comprising the first conductive layer 123-1 and the second conductive layer 123-2 and the auxiliary electrode can be prevented. In addition, since the uniformity of the film thickness of the first conductive layer is secured, the stability of the production quality can be improved.

When the second conductive layer 123-2 is formed on the first conductive layer 123-1, there is no need to adjust or manage the deposition angle to deposit the first conductive layer 123-1 using an evaporation source. In addition, even if the first conductive layer 123-1 as well as the blue organic light-emitting layer 122b using an evaporation source is freely deposited without being restricted by the deposition angle, the blue organic light-emitting layer 122b may be deposited on the corresponding subpixels SPr, SPg, and SPb, and the blue cathode electrode 123b may be stably connected to the auxiliary electrode of the protrusion part 127 by the second conductive layer 123-2. Therefore, when configured with a combination of the aforementioned connection structures 124-1 and 124-2 and the open structures 134-1 and 134-2, productivity and material utilization efficiency can be improved through a more free deposition process.

In addition, when the organic light-emitting display device is implemented in a top emission manner, the luminescence efficiency can be improved by utilizing constructive interference between the anode electrode 121b and the blue cathode electrode 123b by using the blue cathode electrode 123b comprising the first conductive layer 123-1 comprising the Ag:Mg alloy and the anode electrode 121b comprising the transflective material.

Meanwhile, the protrusion part 127 may be locally formed in a dot shape only between a plurality of blue subpixels SPb in the second direction Y. In this instance, in regions where the corresponding protrusion part 127 is not formed, as illustrated in FIG. 7, the blue organic light-emitting layer 122b and the blue cathode electrode 123b may be continuously connected to the adjacent blue subpixel SPb on the first bank 111-1 without interruption.

Meanwhile, a plurality of waterproof structures 128-1 and 128-2 may be disposed on the side portions of the protrusion part 127. For example, a third inorganic insulating layer 135-3 may be formed on a plurality of undercut structures 127a and 127b formed on the side portions of the protrusion part 127. For example, the third inorganic insulating layer 135-3 may be formed in a curved shape on the plurality of undercut structures 127a and 127b. For example, a plurality of waterproof structures 128-1 and 128-2 having a curved shape, respectively, may be formed by disposing the third inorganic insulating layer 135-3 on the upper side of the floor layer 161, the side portions of the pillar layer 162, and the lower side of the roof layer 163 in the plurality of undercut structures 127a and 127b.

The plurality of waterproof structures 128-1 and 128-2 may also be formed by the first inorganic insulating layer 135-1 disposed on the plurality of red subpixels SPr in the second direction Y or the second inorganic insulating layer 135-2 disposed on the plurality of green subpixels SPg in the second direction Y.

Meanwhile, the open structures 138-1 and 138-2 may be formed by the undercut structure formed on an edge region of the lower side of the first bank 111-1.

The open structures 138-1 and 138-2 may comprise at least one or more blocking layer 113 for forming an undercut structure that is recessed inwardly from the side portions of the first bank 111-1. The undercut structure formed by the blocking layer 113 that is recessed inwardly from the side portions of the first bank 111-1 may be formed by the open structures 138-1 and 138-2.

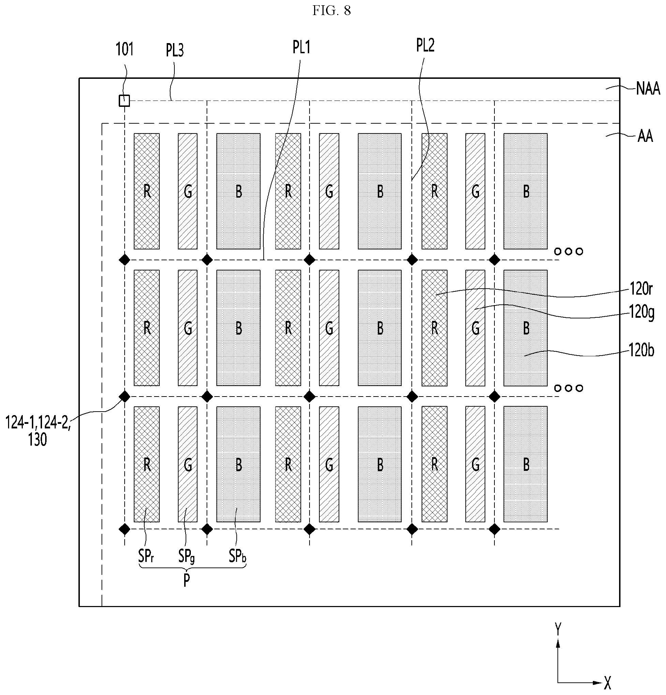

FIG. 8 is a plan view schematically illustrating an organic light-emitting display device according to a third embodiment.

The third embodiment is identical to the second embodiment (FIG. 2) except for the connection structures 124-1, 124-2, and 130. In the third embodiment, the same drawing reference numerals are given to components having the same shape, structure, and/or function as those of the second embodiment (FIG. 2), and detailed descriptions are omitted.

As illustrated in FIG. 8, a plurality of connection structures 124-1, 124-2, and 130 may be disposed in a plurality of intersection regions where a plurality of first power wires PL1 and a plurality of second power wires PL2 intersect. The plurality of connection structures 124-1, 124-2, and 130 may be connection structures 124-1, 124-2, and 130 illustrated in FIGS. 4 to 6. The connection structures 124-1, 124-2 and 130 may electrically connect the cathode electrodes of the plurality of subpixels SPr, SPg and SPb to the first power wiring PL1 and the second power wiring PL2.

The plurality of first power wiring PL1 and the plurality of second power wiring PL2 may be disposed in the display region AA, and the third power wiring PL3 may connect the plurality of second power wiring PL2 to the power terminal 101 in the non-display region NAA.

At least three or more subpixels may share one connection structure 124-1, 124-2 and 130. That is, at least three or more subpixels may be commonly connected to one connection structure 124-1, 124-2 and 130. For example, the cathode electrodes of two adjacent green subpixels SPg and two adjacent blue subpixels SPb may be electrically connected in common to one connection structure 124-1, 124-2 and 130.

In the second embodiment (FIG. 2), a plurality of connection structures 124-1, 124-2 and 130 may be disposed between a plurality of subpixels SPr, SPg and SPb in the second direction Y, whereas in the third embodiment (FIG. 8), a plurality of connection structures 124-1, 124-2 and 130 may be disposed in a plurality of intersection regions where a plurality of first power wiring PL1 and a plurality of second power wiring PL2 intersect.

According to an embodiment, since at least three or more subpixels share one connection structure 124-1, 124-2, and 130, the number of connection structures 124-1, 124-2, and 130 can be reduced, so that the process time can be reduced and the possibility of defects in the process can be minimized.

In addition, in the process of patterning by color pattern in Fig. 8, the connection structures 124-1, 124-2, and 130 may be illustrated as being shared with adjacent subpixels, but as shown in Fig. 2, they may be patterned to be connected only to subpixels of the corresponding color within the stripe pattern of the same color. Through these structures, the factor of yield reduction due to complexity resulting from sharing connection structures 124-1, 124-2, and 130 can be improved.

For example, as illustrated in FIG. 8, the shapes of the patterns for patterning a plurality of green subpixels in the second row line may be patterned to comprise a right connection structures 124-1, 124-2, and 130 between a first row and a second row. In addition, the shapes of the patterns for patterning a plurality of green subpixels on the second row line do not be patterned to comprise the right connection structures 124-1, 124-2, and 130 between the second row and a third row.

In this way, by dividing adjacent subpixels while alternating the nth row and the n+1th row, and by disposing the connection structures 124-1, 124-2, and 130 in a region where four subpixels intersect and are easy to design, the EAR can be improved.

According to the embodiment, since the plurality of connection structures 124-1, 124-2 and 130 are not disposed between the plurality of subpixels SPr, SPg and SPb in the second direction Y, the emission region of each subpixel can be increased, thereby improving the product's lifespan and brightness.

Meanwhile, as illustrated in FIG. 8, since the connection structures 124-1, 124-2 and 130 are disposed in the plurality of intersection regions where the plurality of first power wiring PL1 and the plurality of second power wiring PL2 intersect, the number of connection structures 124-1, 124-2 and 130 can be reduced. In addition, the connection structures 124-1, 124-2 and 130 may be electrically connected to at least two regions of each of the plurality of subpixels adjacent to the connection structures 124-1, 124-2 and 130. The electrical connection method may comprise a laser ablation process, a laser welding process, a method using an undercut structure (138 in FIG. 5), etc.

In the arrangement structure in stripe pixel illustrated in FIG. 2 or FIG. 8, the third power wiring PL3 may be electrically connected to the second power wiring PL2 in the non-display region NAA.

In FIG. 2 or FIG. 8, all subpixels may be disposed to be connected to the connection structures 124-1, 124-2, and 130. However, in the display region AA, even if the second power wiring PL2 is electrically connected to one subpixel in units of 10 to 20 subpixels along the second direction Y through the connection structures 124-1, 124-2, and 130, a power, for example, the first potential voltage, may be uniformly applied. Therefore, the number of connection structures 124-1, 124-2 and 130 can be reduced to 1/8 of the number of connection structures 124-1, 124-2 and 130 illustrated in FIG. 2 or FIG. 8. In addition, even if a plurality of connection structures 124-1, 124-2 and 130 are randomly disposed, the EAR can be dramatically improved. Reducing the number of connection structures 124-1, 124-2 and 130 may also contribute to improved productivity, improved yield and improved reliability.

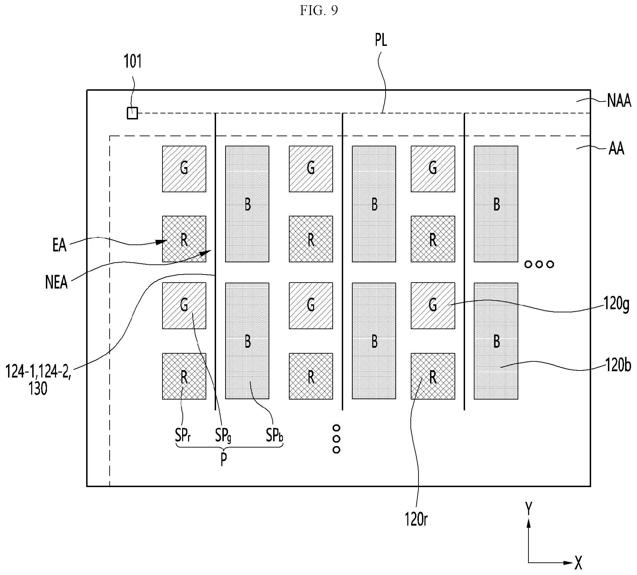

FIG. 9 is a plan view schematically illustrating an organic light-emitting display device according to a fourth embodiment.

The fourth embodiment is the same as the first embodiment (FIG. 1) except for the arrangement structure of the plurality of subpixels SPr, SPg and SPb. In the fourth embodiment, the same drawing reference numerals are given to components having the same shape, structure, and/or function as those of the first embodiment (FIG. 1), and detailed descriptions are omitted.

As illustrated in FIG. 9, the plurality of subpixels SPr, SPg, and SPb may comprise a plurality of red subpixels SPr, a plurality of green subpixels SPg, a plurality of blue subpixels SPb, etc. The plurality of red subpixels SPr may emit a first color, the plurality of green subpixels SPg may emit a second color, and the plurality of blue subpixels SPb may emit a third color.

The plurality of red subpixels SPr may be arranged along the second direction Y. The plurality of green subpixels SPg may be arranged between the plurality of red subpixels SPr in the second direction Y. The plurality of blue subpixels SPb may be arranged parallel to the plurality of red subpixels SPr and the plurality of green subpixels SPg in the second direction Y. For example, an area of the blue subpixel SPb may be equal to or similar to the sum of an area of the red subpixel SPr and an area of the green subpixel SPg.

Meanwhile, the plurality of connection structures 124-1, 124-2, and 130 may be disposed lengthwise along the second direction Y. The plurality of connection structures 124-1, 124-2, and 130 may be the connection structures 124-1, 124-2, and 130 illustrated in FIGS. 4 to 6. The connection structures 124-1, 124-2, and 130 may electrically connect the cathode electrodes of the plurality of subpixels SPr, SPg, and SPb to the power wiring PL in the non-display region NAA.

The plurality of connection structures 124-1, 124-2, and 130 may be disposed in units of two subpixels or two column lines along the first direction X. The connection structures 124-1, 124-2 and 130 may be disposed between the red subpixel SPr and the blue subpixel SPb and between the green subpixel SPg and the blue subpixel SPb. In this instance, the red subpixel SPr, the green subpixel SPg and the blue subpixel SPb may share one connection structure 124-1, 124-2 and 130. That is, the red subpixel SPr, the green subpixel SPg and the blue subpixel SPb may be commonly connected to one connection structure 124-1, 124-2 and 130.

According to an embodiment, the plurality of connection structures 124-1, 124-2 and 130 may be disposed lengthwise along the second direction Y between the plurality of subpixels SPr, SPg and SPb in the first direction X. Accordingly, the plurality of connection structures 124-1, 124-2, and 130 may be disposed lengthwise in a stripe shape along the second direction Y and are electrically connected to the power wiring PL on the non-display region NAA, thereby reducing the complexity of the process.

According to the embodiment, the plurality of connection structures 124-1, 124-2, and 130 may be commonly connected to one connection structure 124-1, 124-2, and 130 along the second direction Y, so that the red subpixel SPr, the green subpixel SPg, and the blue subpixel SPb may be commonly connected to one connection structure 124-1, 124-2, and 130. Accordingly, since the cathode electrode having a wider area is electrically connected to the power wiring PL, the same or similar voltage may be strongly generated regardless of the position of the panel, thereby improving the image quality.

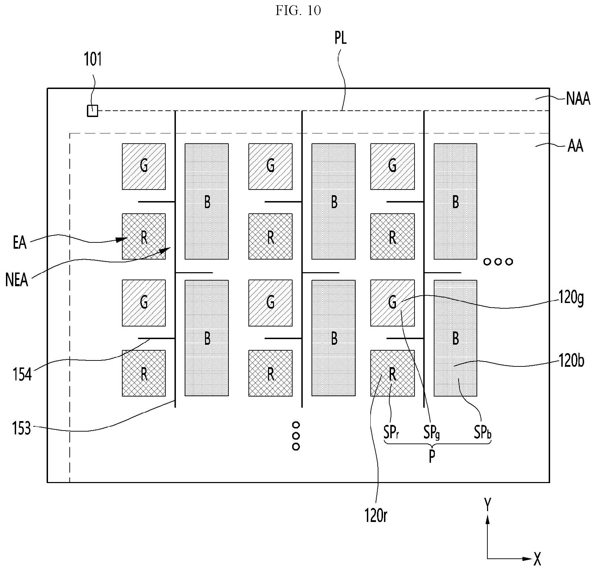

FIG. 10 is a plan view schematically illustrating an organic light-emitting display device according to a fifth embodiment.

The fifth embodiment is the same as the first embodiment (FIG. 1) except for the plurality of connection structures 153 and 154. In the fifth embodiment, the same drawing reference numerals are given to components having the same shape, structure, and/or function as the first embodiment (FIG. 1), and detailed descriptions are omitted.

As illustrated in FIG. 10, the plurality of red subpixels SPr may be arranged along the second direction Y. The plurality of green subpixels SPg may be arranged between the plurality of red subpixels SPr in the second direction Y. The plurality of blue subpixels SPb may be arranged parallel to the plurality of red subpixels SPr and the plurality of green subpixels SPg in the second direction Y.

The plurality of connection structures may comprise a plurality of first connection structures 153 and a plurality of second connection structures 154.

The plurality of first connection structures 153 may be disposed lengthwise along the second direction Y. The plurality of first connection structures 153 may be disposed in units of two subpixels or two column lines along the first direction X. The first connection structure 153 may be disposed between the red subpixel SPr and the blue subpixel SPb and between the green subpixel SPg and the blue subpixel SPb. In this instance, the red subpixel SPr, the green subpixel SPg, and the blue subpixel SPb may share one first connection structure 153. That is, the red subpixel SPr, the green subpixel SPg, and the blue subpixel SPb may be commonly connected to one first connection structure 153.

The plurality of second connection structures 154 may be branched in the first direction X from the plurality of first connection structures 153.

For example, the plurality of second connection structures 154 may extend between the red subpixels SPr and the green subpixels SPg in the plurality of first connection structures 153.

For example, the plurality of second connection structures 154 may be disposed in units of two subpixels or two column lines along the second direction Y. For example, the plurality of second connection structures 154 may be disposed between the green subpixels SPg and the red subpixels SPr along the second direction Y, but may not be disposed between the red subpixels SPr and the green subpixels SPg, but is not limited thereto.

For example, the plurality of second connection structures 154 may extend between the plurality of blue subpixels SPb in the second direction Y in the plurality of first connection structures 153.

Although not illustrated, both sides of the second connection structure 154 may be electrically connected to adjacent first connection structures 153.

Unlike the fourth embodiment (FIG. 9), in the fifth embodiment (FIG. 10), since a plurality of second connection structures 154 extending between the red subpixel SPr and the green subpixel SPg may be added, the electrical contact area for the cathode electrodes of each of the red subpixel SPr and the green subpixel SPg may be increased, so that the product's lifespan and brightness can be improved by providing a smooth current supply.

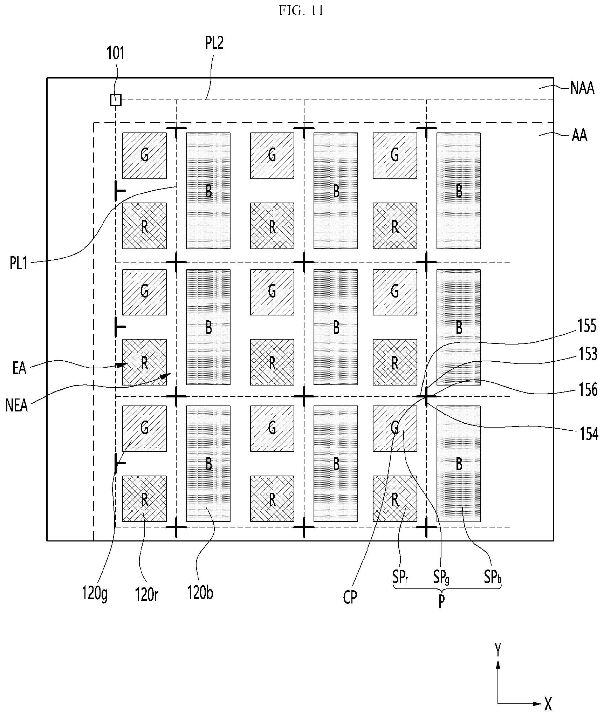

FIG. 11 is a plan view schematically illustrating an organic light-emitting display device according to a sixth embodiment.

As shown in FIG. 11, the plurality of connection structures 153 to 156 may comprise two or more connection structures branching from a plurality of intersection points CP between the plurality of red subpixels SPr, the plurality of green subpixels SPg, and the plurality of blue subpixels SPb.

For example, the plurality of connection structures may comprise a plurality of first connection structures 153, a plurality of second connection structures 154, a plurality of third connection structures 155, a plurality of fourth connection structures 156, etc.

The first connection structure 153 may be branched between the red subpixel SPr and the blue subpixel SPb at the intersection point CP, and may be shared by the red subpixel SPr and the blue subpixel SPb. That is, the red subpixel SPr and the blue subpixel SPb may be electrically connected in common to the first connection structure 153. For example, the cathode electrodes of the red subpixel SPr and the blue subpixel SPb may be connected in common to the first connection structure 153.

The second connection structure 154 may be branched between the green subpixel SPg and the blue subpixel SPb at the intersection point CP, and may be shared by the green subpixel SPg and the blue subpixel SPb. That is, the green subpixel SPg and the blue subpixel SPb may be electrically connected in common to the second connection structure 154. For example, the cathode electrodes of the green subpixel SPg and the blue subpixel SPb may be commonly connected to the second connection structure 154.

The plurality of power wires may comprise a plurality of first power wires PL1 and a second power wire PL2. The plurality of first power wires PL1 may be disposed between the plurality of red subpixels SPr and the plurality of blue subpixels SPb and between the plurality of green subpixels SPg and the plurality of blue subpixels SPb in the display region AA. The plurality of first power wires PL1 may be arranged in units of two column lines or two subpixels along the first direction X. The plurality of first power wiring PL1 may be disposed to be connected to each other in the first direction X and the second direction Y in a matrix form. The second power wiring PL2 may connect the power terminal 101 to the plurality of first power wiring PL1 in the non-display region NAA. In this instance, a plurality of first connection structures 153 and a plurality of second connection structures 154 may be disposed corresponding to the plurality of first power wiring PL1.

The third connection structure 155 may be branched between the red subpixel SPr and the green subpixel SPg at the intersection point CP, and may be shared by the red subpixel SPr and the green subpixel SPg. That is, the red subpixel SPr and the green subpixel SPg may be electrically connected in common to the third connection structure 155. For example, cathode electrodes of the red subpixel SPr and the green subpixel SPg may be commonly connected to the third connection structure 155.

The fourth connection structure 156 may be branched between adjacent blue subpixels SPb at the intersection point CP, and may be shared by the adjacent blue subpixels SPb. That is, the adjacent blue subpixels SPb may be electrically connected in common to the fourth connection structure 156. For example, the cathode electrodes of the adjacent blue subpixels SPb may be commonly connected to the fourth connection structure 156.

According to an embodiment, two or more connection structures branched at the intersection point CP between the plurality of red subpixels SPr, the plurality of green subpixels SPg, and the plurality of blue subpixels SPb may be disposed. Accordingly, two side portions which are in contact with at least two corners of the cathode electrodes of each of the plurality of subpixels SPr, SPg, and SPb may be electrically connected to the first power wiring PL1. Accordingly, the emission area of each of the plurality of subpixels SPr, SPg, and SPb can be increased, and the electrical contact area for the cathode electrode can be increased, so that the product's lifespan and brightness can be improved.

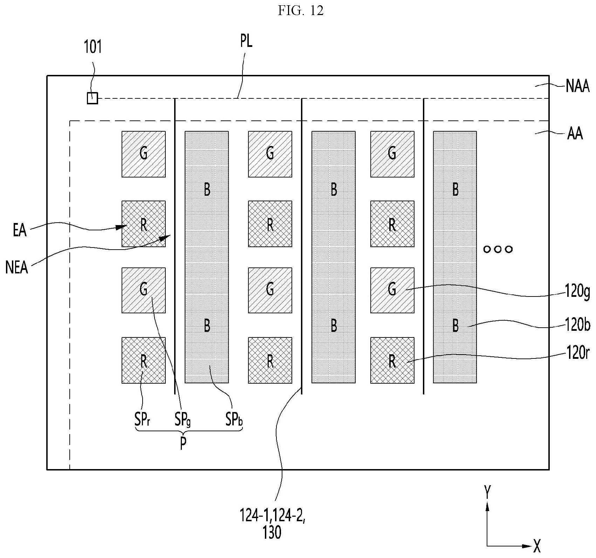

FIG. 12 is a plan view schematically illustrating an organic light-emitting display device according to a seventh embodiment.

The seventh embodiment is the same as the fourth embodiment (FIG. 9) except for the arrangement structure of the plurality of subpixels SPr, SPg, and SPb. In the seventh embodiment, the same drawing reference numerals are given to components having the same shape, structure, and/or function as those of the fourth embodiment (FIG. 9), and a detailed description is omitted.

In the seventh embodiment (FIG. 12), the arrangement structure of the plurality of red subpixels SPr and the plurality of green subpixels SPg may be the same as those of the fourth embodiment (FIG. 9).

In the fourth embodiment (FIG. 9), the blue subpixels SPb may be disposed separately along the second direction Y, whereas in the seventh embodiment (FIG. 12), the blue subpixels SPb may be disposed in a stripe shape along the second direction Y. That is, in the fourth embodiment (FIG. 9), the blue organic light-emitting layer and the blue cathode electrode of the blue organic light-emitting element 120b may be separated in a unit of a single subpixel or a single row line. In contrast, in the seventh embodiment (FIG. 12), the blue organic light-emitting layer and the blue cathode electrode of the blue organic light-emitting element 120b may be continuously connected along the second direction Y without interruption in a stripe shape.

Similar to the fourth embodiment (FIG. 9), in the seventh embodiment (FIG. 12), the plurality of connection structures 124-1, 124-2, and 130 may be disposed lengthwise along the second direction Y between the plurality of red subpixels SPr and the plurality of blue subpixels SPb, and between the plurality of green subpixels SPg and the plurality of blue subpixels SPb.

The pixel arrangement of FIGS. 9 to 12 may be a structure in which the red subpixel SPr is disposed in a long stripe pattern in the second direction Y, and the red subpixel SPr and green subpixel SPg are each disposed in a dot shape, so that it is easy to expand the area of the blue subpixel SPb with a short lifespan.

In order to maximize the lifespan of the product, the area of the blue subpixel SPb with the shortest lifespan may occupy about 55 to 70% of the area of one pixel. In this instance, it is easy to optimize the design for the ratio of the area of one pixel, and the image quality may be excellent in displaying characters, etc.

FIGS. 9 to 12 may be examples of optimizing the arrangement of connection structures 124-1, 124-2, and 130 in the pixel arrangement structure in which the dot shape and stripe pattern described above are mixed.

As shown in FIGS. 9, 10, and 12, connection structures 124-1, 124-2, and 130 in the form of lines or bars may be disposed on another power wiring connected to the power wiring PL of the non-display region NAA below, and connection structures 124-1, 124-2, and 130 of undercut structures 127a and 127b provided on the first protrusion part 127 connected to another power wiring on another power wiring may be disposed.

For example, as illustrated in FIG. 9, the deposition angle of the cathode electrode material of the blue subpixel SPb and the deposition angle of the cathode electrode material of each of the red subpixel SPr and the green subpixel SPg may be disposed to face in opposite directions.

Although not illustrated, in order to improve the degree of freedom of operation of the deposition equipment according to these deposition angles, a plurality of protruding undercut connection structures 124-1, 124-2, and 130 may be disposed in a point or dot shape rather than a line shape along the second direction Y, as illustrated in FIG. 2, in the blue subpixel SPb.

The above detailed description should not be construed as limiting in all respects and should be considered illustrative. The scope of the embodiment should be determined by reasonable interpretation of the appended claims, and all changes within the equivalent range of the embodiment are included in the scope of the embodiment.

## Claims

1. An organic light-emitting display device, comprising:
a power wiring;
a plurality of subpixels;
a plurality of organic light-emitting elements in the plurality of subpixels; and
a plurality of connection structures configured to connect a plurality of cathode electrodes of the plurality of organic light-emitting elements to the power wiring around the plurality of subpixels,
wherein the plurality of subpixels have different colors along a first direction and have a same color along a second direction intersecting the first direction.

2. The organic light-emitting display device of claim 1, wherein the plurality of connection structures are disposed lengthwise along the second direction between the plurality of subpixels.

3. The organic light-emitting display device of claim 1, wherein the plurality of connection structures are disposed between the plurality of subpixels in the second direction.

4. The organic light-emitting display device of claim 1, wherein the power wiring comprises:
a plurality of first power wirings along the first direction; and
a plurality of second power wirings intersecting the plurality of first power wirings along the second direction,
wherein the plurality of connection structures are disposed in intersection regions where the plurality of first power wirings and the plurality of second power wirings intersect.

5. The organic light-emitting display device of claim 1, further comprising:
a plurality of banks between the plurality of subpixels; and
a plurality of protrusion parts comprising a bottom layer, a pillar layer on the bottom layer, and a roof layer on the pillar layer, respectively, on the plurality of banks, wherein the protrusion part has undercut structures formed by the bottom layer, the pillar layer, and the roof layer.

6. The organic light-emitting display device of claim 5, wherein at least one layer of the floor layer and the pillar layer is an auxiliary electrode connected to the power wiring, and
wherein the connection structure is in contact with the cathode electrode with an upper surface of the auxiliary electrode in the undercut structure.

7. The organic light-emitting display device of claim 5, further comprising:
an inorganic insulating layer on the plurality of organic light-emitting elements; and
waterproof structures in the undercut structures.

8. The organic light-emitting display device of claim 7, wherein the waterproof structure is configured to be formed in a curved shape by the inorganic insulating layer with the undercut structure.

9. The organic light-emitting display device of claim 1, further comprising:
an open structure between the plurality of subpixels,
wherein a hole injection layer or a charge generation layer of the organic light-emitting layer is separated by the open structure.

10. An organic light-emitting display device, comprising:
a power wiring;
a plurality of subpixels;
a plurality of organic light-emitting elements in the plurality of subpixels; and
a plurality of connection structures configured to connect a plurality of cathode electrodes of the plurality of organic light-emitting elements to the power wiring around the plurality of subpixels,
wherein the plurality of subpixels comprises:
a plurality of first subpixels along a second direction;
a plurality of second subpixels between the plurality of first subpixels in the second direction; and
a plurality of third subpixels arranged in parallel with the plurality of first subpixels and the plurality of second subpixels in the second direction.

11. The organic light-emitting display device of claim 10, wherein the plurality of connection structures are disposed lengthwise along the second direction between the plurality of first subpixels and the plurality of third subpixels and between the plurality of second subpixels and the plurality of third subpixels.

12. The organic light-emitting display device of claim 10, wherein the plurality of connection structures comprise:
a plurality of first connection structures disposed lengthwise along the second direction between the plurality of first subpixels and the plurality of third subpixels and between the plurality of second subpixels and the plurality of third subpixels; and
a plurality of second connection structures configured to branch in the first direction from the plurality of first connection structures.

13. The organic light-emitting display device of claim 10, wherein the plurality of connection structures comprise:
two or more connection structures configured to branch at a plurality of intersection points between the plurality of first subpixels, the plurality of second subpixels, and the plurality of third subpixels.
